# EUROPEAN PATENT SPECIFICATION

(11) **EP 2 535 936 B1**
(45) Date of publication and mention of the grant of the patent: **23.10.2013**
(21) Application number: 11182663.2
(22) Date of filing: 26.09.2011
(51) Int. Cl.: H01L 29/45, H01L 29/786

(54) **Thin film transistor, thin film transistor panel and methods for manufacturing the same**
Dünnfilmtransistor, Dünnfilmtransistorpanel und deren Herstellungsverfahren
Transistor à couche mince, panneau de transistor à couche mince et leurs procédés de fabrication

(30) Priority: 14.06.2011 KR 20110057366
(43) Date of publication of application: 19.12.2012
(73) Proprietor: Samsung Display Co., Ltd., Yongin-City, Gyeonggi-Do (KR)
(72) Inventor: Sung-Haeng, Cho, 442-742 Gyeonggi-do (KR); Park, Jae-Woo, 442-742 Gyeonggi-do (KR); Kim, Do-Hyun, 442-742 Gyeonggi-do (KR)
(74) Representative: Dr. Weitzel & Partner

(56) References cited:
- US-A1- 2009 321 937
- US-A1- 2011 057 186

## Description

### BACKGROUND OF THE INVENTION

### 1. Field of the invention

The invention relates to a thin film transistor and a thin film transistor panel having an oxide semiconductor and methods for manufacturing the same, and more particularly to a thin film transistor and a thin film transistor panel having a layer preventing an atom included in the oxide semiconductor or another layer from being extracted or diffused, and methods for manufacturing the same.

### 2. Description of the Related Art

In general, wirings or electrodes including chrome (Cr), aluminum (A1), molybdenum (Mo), or an alloy thereof are mainly used in semiconductor devices or liquid crystal display devices. For microfabrication of the semiconductor devices having high integration and a fast operating speed, copper (Cu) which has a lower electric resistance compared to aluminum, and has a higher resistance to electromigration and stress migration, has been used as the wirings or the electrodes in the semiconductor devices.

Even in the field of display devices represented by the liquid crystal display devices and the like, low resistance wirings are required due to the increase in resolution and display area, and the integration of devices including sensors and driver circuits, which may be integrated in the display devices.

Therefore, gate or data wirings made of copper, or gate, drain and source electrodes of a thin film transistor ("TFT"), which are also made of copper, are applied to the display devices.

However, when copper is used as wirings or electrodes, the diffusion of copper into adjacent circuit elements or a semiconductor layer of the TFT degrades characteristics of the circuit elements of the TFT. A diffusion barrier layer for preventing diffusion of copper into the semiconductor layer may degrade characteristics of the TFT. For example, an oxide semiconductor layer has been used as the semiconductor layer of the TFT due to its high mobility, but the diffusion barrier layer, including indium (In) or titanium (Ti), renders the semiconductor layer poor by deoxidization or extraction of cations included in the oxide semiconductor layer.

Therefore, it is required to prevent a metal atom or an ion from being diffused, deoxidized, or extracted into an adjacent layer. Also, it is required that a process for manufacturing the TFT, including an oxide semiconductor and copper wiring or electrode, is more simplified.

### BRIEF SUMMARY OF THE INVENTION

Exemplary embodiments of the invention address at least the above-mentioned problems and/or disadvantages and provide at least the advantages described below. Accordingly, an exemplary embodiment of the invention provides a thin film transistor ("TFT") and a TFT panel including a preventing layer having gallium zinc oxide (GaZnO), and methods for manufacturing the same.

Another exemplary embodiment of the invention provides simplified methods for simply manufacturing a TFT or a TFT panel having an oxide semiconductor.

In accordance with one exemplary embodiment of the invention, there is provided a TFT including a gate electrode, a gate insulating layer, an oxide semiconductor layer on the gate insulating layer, and a drain electrode and a source electrode on the oxide semiconductor layer and spaced apart from each other. The drain electrode includes a first drain sub-electrode on the oxide semiconductor layer, and a second drain sub-electrode on the first drain sub-electrode. The source electrode includes a first source sub-electrode on the oxide semiconductor layer, and a second source sub-electrode on the first source sub-electrode. The first drain sub-electrode and the first source sub-electrode include gallium zinc oxide (GaZnO), and the second source sub-electrode and the second drain sub-electrode include a metal atom.

The first source sub-electrode or the first drain sub-electrode may substantially be transparent.

The gallium zinc oxide (GaZnO) may include about 2 atomic % to about 20 atomic % of gallium, and about 80 atomic % to about 98 atomic % of zinc.

The drain electrode has a third drain sub-electrode on the second drain sub-electrode, and the source electrode has a third source sub-electrode on the second source sub-electrode. The third drain sub-electrode and the third source sub-electrode include copper manganese nitride (CuMn).

The first source sub-electrode or the first drain sub-electrode may be about 50 angstroms (Å) to about 1,000Å thick.

A carrier concentration of the first source sub-electrode or the first drain sub-electrode may be higher than a carrier concentration of the oxide semiconductor layer.

A carrier concentration of the first source sub-electrode or the first drain sub-electrode may be about 10¹⁷/cm³ to about 10²¹/cm³.

### BRIEF DESCRIPTION OF THE DRAWINGS

The above and other features of the invention will become more apparent by describing in detail exemplary embodiments thereof with reference to the accompanying drawings, in which:
FIG. 1 is a cross-sectional view of an exemplary embodiment of a thin film transistor ("TFT") according to the invention;
FIGS. 2A to 2G are cross-sectional views illustrating exemplary embodiments of a method for manufacturing the TFT shown in FIG. 1 according to the invention;
FIGS. 3A to 3B are graphs illustrating TFT characteristics according to the invention;
FIG. 4 is a cross-sectional view of another exemplary embodiment of a TFT according to the invention;
FIGS. 5A to 5I are cross-sectional views of exemplary embodiments of a method for manufacturing the TFT shown in FIG. 4 according to the invention;
FIG. 6 is a plan view of an exemplary embodiment of a TFT panel according to the invention; and
FIGS. 7A to 7B are cross-sectional views of exemplary embodiments taken along line 7-7' of the TFT panel shown in FIG. 6 according to the invention.

### DETAILED DESCRIPTION OF THE INVENTION

Exemplary embodiments of the invention will now be described in detail with reference to the accompanying drawings. In the following description, specific details such as configuration and components are merely provided to assist the overall understanding of exemplary embodiments of the invention. Therefore, it should be apparent to those skilled in the art that various changes and modifications of the embodiments described herein can be made without departing from the scope and spirit of the invention. In addition, descriptions of well-known functions and constructions are omitted for clarity and conciseness. Throughout the drawings, the same drawing reference numerals will be understood to refer to the same elements, features and structures.

It will be understood that when an element or layer is referred to as being "on" and "connected to" another element or layer, the element or layer can be directly on or connected to another element or layer or intervening elements or layers. In contrast, when an element is referred to as being "directly on" or "directly connected to" another element or layer, there are no intervening elements or layers present. As used herein, connected may refer to elements being physically and/or electrically connected to each other. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "under," "above," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" or "under" relative to other elements or features would then be oriented "upper" or "above" relative to the other elements or features. Thus, the exemplary term "lower" and "under" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the invention will be described in detail with reference to the accompanying drawings.

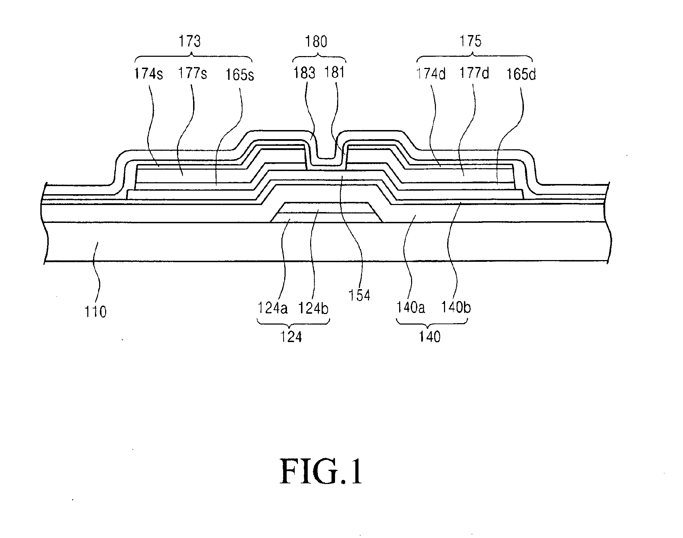

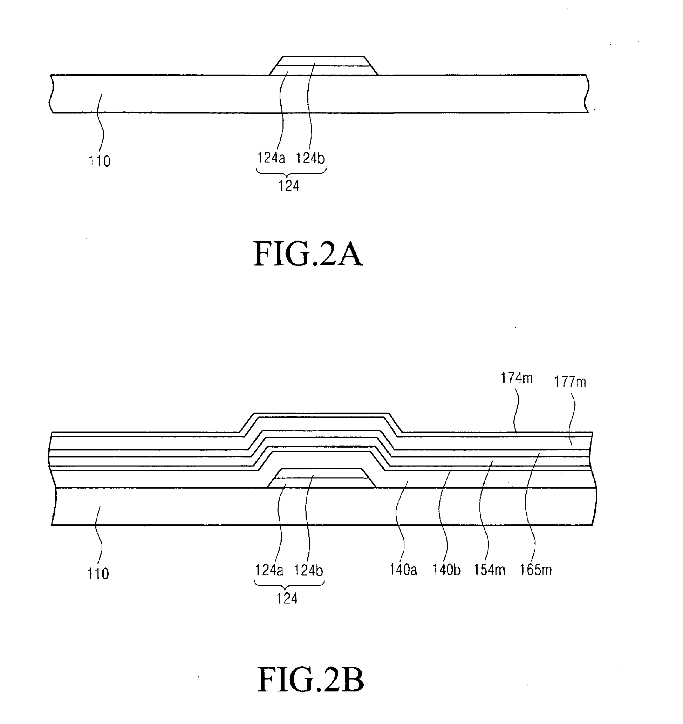

Exemplary embodiments of a thin film transistor ("TFT") and a manufacturing method thereof according to the invention will be described in detail with reference to FIG. 1 and FIGS. 2A to 2G. FIG. 1 is a cross-sectional view of an exemplary embodiment of a TFT according to the invention. FIGS. 2A To 2G are cross-sectional views illustrating an exemplary embodiment of a method for manufacturing the TFT shown in FIG. 1 according to the invention. A structure of a TFT will now be described in detail with reference to FIG. 1.

A TFT illustrated in FIG. 1 has a gallium-zinc oxide (GaZnO) group layer including any one surface directly contacting an oxide semiconductor layer and another surface directly contacting a copper (Cu) layer or a copper alloy layer. A gate electrode 124 is on a transparent substrate 110 including single crystal, polycrystal, glass, or plastic materials. In one exemplary embodiment of the invention, the gate electrode 124 has a double-layer structure including a first gate sub-electrode 124a including titanium (Ti) or a titanium alloy, and a second gate sub-electrode 124b including copper (Cu) or a copper alloy. The first gate sub-electrode 124a may be about 50 angstroms (A) to about 1,000Å thick, and the second gate sub-electrode 124b may be about 1,000Å to about 10,000Å thick. Thicknesses are taken perpendicular to the transparent substrate 110. The gate electrode 124 controls a current flowing through a channel formed between a source electrode 173 and a drain electrode 175, based on a voltage being applied to the gate electrode 124.

The gate electrode 124 may have the double-layer or a triple-layer structure. In exemplary embodiments, for example, the double-layer structure may include Al/Mo, Al/Ti, Al/Ta, Al/Ni, Al/TiNx, Al/Co, Cu/CuMn, Cu/Ti, Cu/TiN, or Cu/TiOx, or the triple-layer structure may include Mo/Al/Mo, Ti/Al/Ti, Co/Al/Co, Ti/Al/Ti, TiNx/Al/Ti, CuMn/Cu/CuMn, Ti/Cu/Ti, TiNx/Cu/TiNx, or TiOx/Cu/TiOx. The gate electrode 124 including a copper-alloy nitride or a copper manganese alloy has good adhesion to a photo resist (not shown). The gate electrode 124 may include a material selected from the group consisting of Cr, Mo, Ti, Ta, Al, Cu, Ag and a mixture thereof according to the invention.

A gate insulating layer 140 is directly on the gate electrode 124. The gate insulating layer 140 may have a double-layer structure including a first gate insulating sub-layer 140a and a second gate insulating sub-layer 140b. In one exemplary embodiment of the invention, the first gate insulating sub-layer 140a may include silicon nitride (SiNx) and the second gate insulating sub-layer 140b may include silicon oxide (SiOx). The first gate insulating sub-layer 140a may be about 1,000Å to about 50,000Å thick. The second gate insulating sub-layer 140b may be about 300Å to about 2,000Å thick. The gate insulating layer 140 may include an inorganic insulating material, an organic insulating material, or an organic/inorganic insulating material. The inorganic insulating material may include silicon nitride (SiNx), silicon oxide (SiOx), titanium oxide (TiO₂), alumina (Al₂O₃), or zirconia (ZrO₂) The organic insulating material may include poly siloxane, phenyl siloxane, polyimide, silsesquioxane, or silane. The organic/inorganic insulating material may include a mixture of at least one material selected from the above-described inorganic insulating materials and at least one material selected from the above-describe organic insulating materials, for example, a mixture of poly siloxane.

A semiconductor layer 154 is directly on the gate insulating layer 140. In an exemplary embodiment of the invention, the semiconductor layer 154 may include indium gallium zinc oxide (InGaZnO). A carrier concentration of the semiconductor layer 154 may be about 10¹⁶ per centimeter cubed (/cm³). The semiconductor layer 154 may be about 200Å to about 1,000Å thick. An oxide semiconductor of the semiconductor layer 154 may be a compound having the formula expressed as AₓBₓOₓ or AₓBₓCₓOₓ, where A may be Zn or Cd, B may be Ga, Sn or In, and C may be Zn, Cd, Ga, In, or Hf In addition, X≠0, and A, B, and C are different from one another. In one exemplary embodiment of the invention, the oxide semiconductor may be a material selected from the group having of InZnO, InGaO, InSnO, ZnSnO, GaSnO, GaZnO, GaZnSnO, GaInZnO, HfInZnO, HfZnSnO and ZnO. An effective mobility of the oxide semiconductor can be about 2 to about 100 times higher than that of hydrogenated amorphous silicon. The semiconductor layer 154 may overlap the gate electrode 124, the source electrode 173 and the drain electrode 175, and forms the channel of the TFT. The TFT channel, through which charges move during an operation of the TFT, is formed in the semiconductor layer 154 between the source electrode 173 and the drain electrode 175.

The source electrode 173 and the drain electrode 175 are directly on the semiconductor layer 154 and are spaced apart from each other. The source electrode 173 includes a first source sub-electrode 165s, a second source sub-electrode 177s and a third source sub-electrode 174s, and the drain electrode 175 includes a first drain sub-electrode 165d, a second drain sub-electrode 177d and a third drain sub-electrode 174d. A lower surface of the first source sub-electrode 165s and the first drain sub-electrode 165d contact the semiconductor layer 154, and an upper surface thereof contact the second source sub-electrode 177s and the second drain sub-electrode 177d. The first source sub-electrode 165s and the first drain sub-electrode 165d include the same material. The first source sub-electrode 165s and the first drain sub-electrode 165d may be about 100Å to about 600Å thick. In an exemplary embodiment of the invention, the first source sub-electrode 165s and the first drain sub-electrode 165d may be substantially transparent in visible rays. The first source sub-electrode 165s and the first drain sub-electrode 165d include gallium zinc oxide (GaZnO). A content ratio of gallium to zinc in the gallium zinc oxide (GaZnO) may be between about 2 atomic percent (at.%) and about 20 at.% : between about 80 at.% and about 98 at.%.

The first source sub-electrode 165s and the first drain sub-electrode 165d can lower the contact resistance between the semiconductor layer 154 and the second source sub-electrode 177s, and between the semiconductor layer 154 and the second drain sub-electrode 177d, respectively. A carrier concentration of the first source sub-electrode 165s or the first drain sub-electrode 165d may be about 10¹⁷/cm³ to about 10²¹/cm³. The carrier concentration may be controlled by adjusting an element and content ratio of the elements included in the first source sub-electrode 165s or the first drain sub-electrode 165d. In an exemplary embodiment of the invention, a carrier concentration of the first source sub-electrode 165s or the first drain sub-electrode 165d may be controlled by including at least one material selected from the group consisting of aluminum (Al), gallium (Ga), boron (B), indium (In), yttrium (Y), scandium (Sc), fluoride (F), vanadium (V), silicon (Si), germanium (Ge), titanium (Ti), zirconium (Zr), hafnium (Hf), antimony (Sb), arsenic (As), niobium(Nb), tantalum (Ta) and a mixture thereof, as a dopant. In an exemplary embodiment of the invention, when the carrier concentration of the first source sub-electrode 165s or the first drain sub-electrode 165d is higher than about 10¹⁷/cm³, the first source sub-electrode 165s and the first drain sub-electrode 165d may not be substantially on the channel portion. In an exemplary embodiment of the invention, a carrier concentration of the first source sub-electrode 165s or the first drain sub-electrode 165d is higher than a carrier concentration of the semiconductor layer 154, for example, an oxide semiconductor layer.

The first source sub-electrode 165s and the first drain sub-electrode 165d can reduce or effectively prevent oxidation of a metal included in the second source sub-electrode 177s and the second drain sub-electrode 177d. Resistivity of the second source sub-electrode 177s and the second drain sub-electrode 177d may increase when the metal, which is included in the second source sub-electrode 177s and the second drain sub-electrode 177d, oxidizes. The first source sub-electrode 165s and the first drain sub-electrode 165d can reduce or effectively prevent extraction and deoxidization of an ion, for example, indium (In), included in the oxide semiconductor layer 154. When the ion included in the oxide semiconductor layer 154 is deoxidized and extracted, a content ratio of the oxide semiconductor layer 154 may be changed so that the TFT characteristics, for example, a mobility of an electric charge and a threshold voltage, may be varied according to a time. Thus, an electrical characteristic of the TFT may be degraded.

The first source sub-electrode 165s and the first drain sub-electrode 165d can prevent an atom from diffusing between the second source sub-electrode 177s or the second drain sub-electrode 177d, and the semiconductor layer 154, respectively. In an exemplary embodiment of the invention, the first source sub-electrode 165s and the first drain sub-electrode 165d including gallium zinc oxide (GaZnO) can effectively prevent a metal atom, for example, copper (Cu), included in the second source sub-electrode 177s and the second drain sub-electrode 177d, from diffusing into the semiconductor layer 154. In an exemplary embodiment of the invention, the first source sub-electrode 165s and the first drain sub-electrode 165d including gallium zinc oxide (GaZnO) can reduce electromigration in a metal atom, for example, copper (Cu), included in the second source sub-electrode 177s and the second drain sub-electrode 177d. In an exemplary embodiment of the invention, the first source sub-electrode 165s and the first drain sub-electrode 165d including the gallium zinc oxide (GaZnO) may be an amorphous structure having substantially no grain boundaries.

The second source sub-electrode 177s is on the first source sub-electrode 165s, and the second drain sub-electrode 177d is on the first drain sub-electrode 165d. The second source sub-electrode 177s is interposed between the first source sub-electrode 165s and the third source sub-electrode 174s. The second drain sub-electrode 177d is interposed between the first drain sub-electrode 165d and the third drain sub-electrode 174d. In an exemplary embodiment of the invention, the second source sub-electrode 177s and the second drain sub-electrode 177d may include copper (Cu). In an exemplary embodiment of the invention, the second source sub-electrode 177s and the second drain sub-electrode 177d include pure copper (Cu). In an exemplary embodiment of the invention, the second source sub-electrode 177s and the second drain sub-electrode 177d may include copper (Cu) of about 99.9 atomic weight percent (wt%) to about 70 atomic wt% and a material, selected from the group consisting of Mn, Mg, Al, Zn, Sn and a combination thereof, of about 0.1 atomic wt% to about 30 atomic wt%. In an exemplary embodiment of the invention, the second source sub-electrode 177s and the second drain sub-electrode 177d may include the material described above with reference to the gate insulating layer 140. The second source sub-electrode 177s and the second drain sub-electrode 177d may be about 1,000Å to about 5,000Å thick.

The third source sub-electrode 174s is on the second source sub-electrode 177s, and the third drain sub-electrode 174d is on the second drain sub-electrode 177d. The third source sub-electrode 174s and the third drain sub-electrode 174d protect the second source sub-electrode 177s and the second drain sub-electrode 177d, respectively. The third source sub-electrode 174s and the third drain sub-electrode 174d can reduce or effectively prevent a material included in the second source sub-electrode 177s and the second drain sub-electrode 177d from reacting with oxygen included in a first protection sub-layer 181 or a second protection sub-layer 183 described below. The third source sub-electrode 174s and the third drain sub-electrode 174d may include copper (Cu)-manganese (Mn) alloy, copper (Cu)-manganese (Mn)-aluminum (Al) alloy, or copper-manganese (Mn)-nitride.

The third source sub-electrode 174s and the third drain sub-electrode 174d may be about 100Å to about 1,000Å thick.

A protection layer 180 may be on and contact the third source sub-electrode 174s and the third drain sub-electrode 174d and/or the semiconductor layer 154. In an exemplary embodiment of the invention, the protection layer 180 may include the first protection sub-layer 181, directly contacting the third source sub-electrode 174s, the third drain sub-electrode 174d and/or the semiconductor layer 154, and the second protection sub-layer 183 directly on the first protection sub-layer 181. In an exemplary embodiment of the invention, the first protection sub-layer 181 may include oxide material. The first protection sub-layer 181 including an oxide material can reduce or prevent a material included in the semiconductor layer 154, which is exposed by the separated area between the source electrode 173 and the drain electrode 175, from being deoxidized and extracted. In an exemplary embodiment of the invention, the first protection sub-layer 181 may include silicon oxide (SiOx), and the second protection sub-layer 183 may include silicon nitride (SiNx). The first protection sub-layer 181 and the second protection sub-layer 183 may be each about 100Å to about 50,000Å thick. In an exemplary embodiment of the invention, the first protection sub-layer 181 may be about 100Å to about 1,000Å thick, and the second protection sub-layer 183 may about 1000Å to about 50,000Å thick. In an exemplary embodiment of the invention, the first protection sub-layer 181 and the second protection sub-layer 183 may include the material described above with reference to the gate insulating layer 140. In an exemplary embodiment of the invention, one of the first protection sub-layer 181 and the second protection sub-layer 183 may be omitted.

The TFT based on the exemplary embodiments of the invention may have excellent characteristics even after driven for a long time.

Exemplary embodiments of methods for manufacturing the TFT illustrated in FIG. 1 will be now described in detail with reference to FIGS. 2A to 2G. Descriptions of materials or structures of the TFT illustrated with reference to FIG. 1 will be omitted to avoid redundant description. Although methods of manufacturing a TFT using all possible materials and structures mentioned with reference to FIG. 1 will not be described hereinbelow, it is apparent that those skilled in the art can easily manufacture a TFT using the above-described materials and structures. FIGS. 2A to 2G are cross-sectional views illustrating an exemplary embodiment of a method for manufacturing the TFT shown in FIG. 1 according to the invention.

Referring to FIG. 2A, a first gate layer (not shown) forming the first gate sub-electrode 124a and a second gate layer (not shown) forming the second gate sub-electrode 124b are stacked on the substrate 110, and then patterned to form the gate electrode 124 including the first gate sub-electrode 124a and the second gate sub-electrode 124b.

An exemplary embodiment of a method for forming the gate electrode 124 having a double-layer structure that includes the first gate sub-electrode 124a having titanium (Ti) or a titanium (Ti) alloy, and the second gate sub-electrode 124b having copper (Cu) or a copper (Cu) alloy according to the invention will be described in detail below. The first gate layer having titanium (Ti) is stacked on the substrate 110, and the second gate layer having copper (Cu) is stacked on the first gate layer. The first gate layer may be about 50Å to about 1,000Å thick, and the second gate layer may be about 1,000Å to about 10.000Å thick. A photo resist (not shown) is formed on the double-layer structure. The photo resist is exposed by a mask with a light passing area and a light blocking area similar to a pattern of the gate electrode 124, and then is developed by a developer. By using the patterned photo resist as a mask, the first gate layer and the second gate layer, which are not covered by the patterned photo resist, are etched by an etching process such as dry etching or wet etching, to form the gate electrode 124.

In one exemplary embodiment of the invention, the first gate layer including titanium (Ti) and the second gate layer including copper (Cu) may be etched by a first etchant described in detail below in a wet etching process. The first etchant may include persulfate, azole-containing compounds, oxidation regulator, composition stabilizer, and oxidation auxiliary. The first etchant may together etch materials of the first gate layer and the second gate layer. The persulfate is a major composition of the oxidizer for etching the copper (Cu) layer. The persulfate may include at least one material selected from the group consisting of ammonium persulfate, potassium persulfate, sodium persulfate, oxone, and a mixture thereof. The azole-containing compounds suppress etching of the copper (Cu) layer. The azole-containing compounds include at least one material selected from the group consisting of benxotriazole, aminoterazole, imidazole, pyrazole, and a mixture thereof. The oxidation regulator regulates oxidation and etching of the copper (Cu) layer. The oxidation regulator may include nitric acid (HNO₃) which is inorganic acid, and acetic acid ("AA") which is organic acid. The composition stabilizer reduces decomposition of the persulfate. The composition stabilizer may include at least one material selected from the group consist of methanse citric acid, nitric acid, phosphoric acid, sulfuric acid, hydrochloric acid, and a mixture thereof. The oxidation auxiliary quickly etches the copper (Cu) layer, and etches the titanium (Ti) layer or the titanium (Ti) alloy layer. The oxidation auxiliary may include fluoride-containing compounds including fluorine (F), for example, at least one material selected from the group consisting of hydrofluoric acid (HF), ammonium fluoride

(NH₄F), ammonium hydrogen fluoride (NH₄HF₂), potassium fluoride (KF), sodium fluoride (NaF), calcium hydrogen fluoride (CaHF), sodium hydrogen fluoride (NaHF₂), ammonium fluoborate (NH₄BF₄), potassium hydrogen fluoride (KHF₂), aluminum fluoride (AlF₃), fluoboric acid-borofluoric acid (HBF₄), lithium fluoride (LiF), potassium fluoroborate (KBF₄), calcium fluoride (CaF₂), fluorosilicate (FS), and a mixture thereof. In one exemplary embodiment of the invention, the etchant for etching the copper (Cu) layer and the titanium (Ti) layer together includes ammonium persulfate of about 12wt%, aminoterazole of about 1wt%, nitric acid (HNO₃) of about 3wt%, acetic acid ("AA") of about 3.2wt%, methane citric acid of about 0.1wt%, and hydrofluoric acid (HF) of about 0.5wt%, except for a solvent. The solvent may be deionized water. In one exemplary embodiment of the invention, materials of the first gate layer and the second gate layer may be etched in sequence by independent etchants.

Referring to FIG. 2B, the first gate insulating sub-layer 140a is formed on the gate electrode 124, and the second gate insulating sub-layer 140b is formed on the first gate insulating sub-layer 140a. The gate insulating layer 140 may include the first gate insulating sub-layer 140a and the second gate insulating sub-layer 140b. In one exemplary embodiment of the invention, the first gate insulating sub-layer 140a may include silicon nitride (SiNx) and the second gate insulating sub-layer 140b may include silicon oxide (SiOx).

A first oxide material 154m is formed on the second gate insulating sub-layer 140b. A second oxide material 165m is formed on the first oxide material 154m. A first metal material 177m is formed on the second oxide material 165m. A second metal material 174m is formed on the first metal material 177m. The first oxide material 154m may include indium gallium zinc oxide (InGaZnO), the second oxide material 165m includes gallium zinc oxide (GaZnO), the first metal material 177m may include copper (Cu), and the second metal material 174m includes copper manganese. The first oxide material 154m, the second oxide material 165m, the first metal material 177m, and the second metal material 174m are patterned to form the semiconductor layer 154, the first source sub-electrode 165s and the first drain sub-electrode 165d, the second source sub-electrode 177s and the second drain sub-electrode 177d, and the third source sub-electrode 174s and the third drain sub-electrode 174d described above with reference to FIG. 1. The silicon nitride (SiNx) and silicon oxide (SiOx) to form the gate insulating layer 140 having the thickness described with reference to FIG. 1 may be formed by chemical vapor deposition ("CVD").

The first oxide material 154m, the second oxide material 165m, the first metal material 177m, and the second metal material 174m, which may be about 200Å to about 1000Å thick, about 100Å to about 600Å thick, about 1,000Å to about 5,000Å thick, and about 100Å to about 1000Å thick, respectively, may be formed by a sputtering technique.

In one exemplary embodiment of the invention, the first oxide material 154m may be a compound having the formula expressed as AₓBₓOₓ or AₓBₓCₓOₓ, where A may be Zn or Cd, B may be Ga, Sn or In, and C may be Zn, Cd, Ga, In, or Hf. In addition, X≠0, and A, B, and C are different from one another. In accordance with another embodiment of the invention, the oxide semiconductor may be a material selected from the group consisting of InZnO, InGaO, InSnO, ZnSnO, GaSnO, GaZnO, GaZnSnO, GaInZnO, HfInZnO, HfZnSnO and ZnO. In one exemplary embodiment of the invention, the first oxide material 154m may be substantially transparent in visible rays.

A carrier concentration and a composition of the gallium zinc oxide (GaZnO), which may be the second oxide material 165m, are the same as those described above with reference to FIG. 1. In one exemplary embodiment of the invention, the second oxide material 165m is the same materials as the materials of the first source sub-electrode 165s and the first drain sub-electrode 165d described above with reference to FIG. 1.

In one exemplary embodiment of the invention, the first metal material 177m or the second metal material 174m including copper (Cu) or copper (Cu) alloy may be formed in a sputtering chamber with an argon (Ar) atmosphere by using a copper (Cu) target. The second metal material 174m may include copper (Cu)-manganese (Mn) alloy, for example, copper (Cu)-manganese (Mn)-nitride. The copper (Cu)-manganese (Mn)-nitride may have better adhesion to a photo resist than a copper (Cu)-manganese (Mn) material. The first metal material 177m under the second metal material 174m including the copper (Cu)-manganese (Mn)-nitride may be etched to have high taper angle by an etching process. The copper (Cu)-manganese (Mn)-nitride may be formed in a sputtering chamber with nitrogen (N₂) gas and argon (Ar) gas by a sputtering technique. In one exemplary embodiment of the invention, the second metal material 174m may include copper manganese-nitride. The second metal material 174m including copper manganese-nitride may be formed by plasma treatment by nitrogen (N₂) given to the surface of the copper manganese. The second metal material 174m including copper manganese-nitride may be formed by a copper manganese annealed in a nitrogen (N₂) atmosphere. In one exemplary embodiment of the invention, the second metal material 174m may be formed of the same material as the materials for forming the third source sub-electrode 174s and the third drain sub-electrode 174d described above with reference to FIG. 1.

In one exemplary embodiment of the invention, manganese oxide (MnOx) may be further formed on the second metal material 174m when a protection layer 180, for example, silicon oxide (SiOx), is formed on the copper (Cu)-manganese (Mn) alloy of the second metal material 174m. The further formed manganese oxide (MnOx) may prevent a material, included in the first metal material 177m, from reacting with oxygen or being extracted to have good adhesion to a photo resist. Therefore, the source electrode 173, the drain electrode 175, and/or a data line (not shown), including the first metal material 177m and the second metal material 174m, may have corrosion resistance.

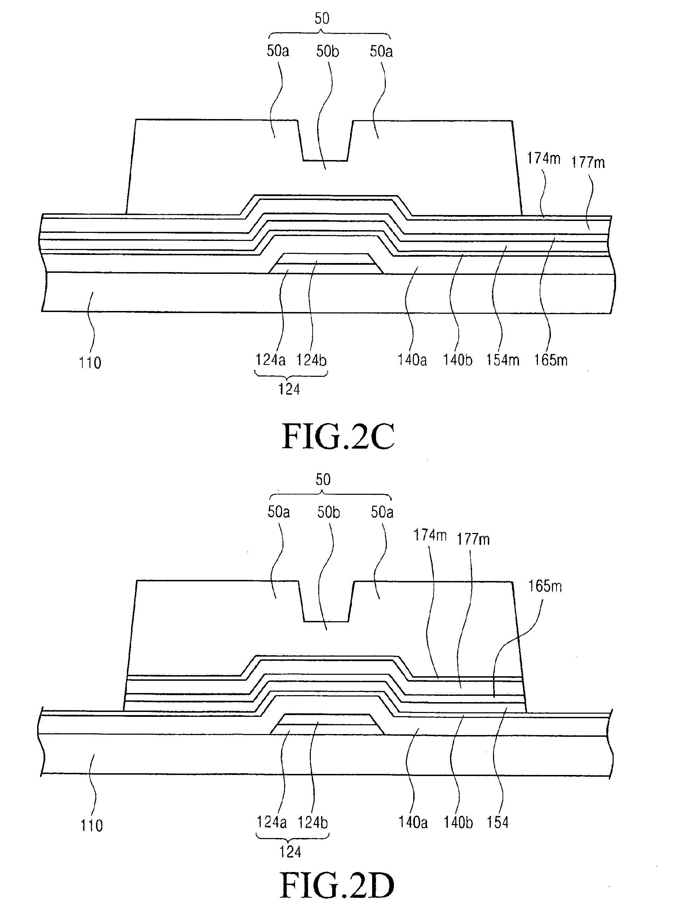

Exemplary embodiments of methods for forming patterns of the semiconductor layer 154, the source electrode 173, and the drain electrode 175 will be described in detail below with reference to FIGS. 2C to 2E. A photo resist is formed on the second metal material 174m, and then the photo resist film 50 is patterned to form the source electrode 173 and the drain electrode 175. The patterned photo resist film 50 may have a thick first portion 50a and a relatively thin second portion 50b, which are formed by using a mask including slit patterns, grid patterns, or a semitransparent layer. That is, a thickness of the first portion 50a is larger than a thickness of the second portion 50b. The second portion 50b corresponds to a channel region of the TFT. In one exemplary embodiment of the invention, the photo resist film 50 may be patterned using interference of the light transmitting slit patterns some of which are 180°-phase delayed patterns.

Exemplary embodiments of an active etching process will be described in detail below with reference to FIG. 2D. The first oxide material 154m, the second oxide material 165m, the first metal material 177m, and the second metal material 174m, uncovered by the photo resist film 50, are etched out in the active etching process. The first oxide material 154m is etched in the active etching process to form the semiconductor layer 154. In one exemplary embodiment of the invention, the first oxide material 154m including indium gallium zinc oxide (InGaZnO), the second oxide material 165m including gallium zinc oxide (GaZnO), the first metal material 177m including copper (Cu), and the second metal material 174m including a copper (Cu)-manganese (Mn) alloy may be etched by the first etchant described with reference to FIG. 2A. In one exemplary embodiment of the invention, an etchant for the active etching process includes oxidizer having ammonium persulfate of 0wt% to about 20wt%, oxidation auxiliary having sulfuric acid of 0wt% to about 3wt%, citric acid of 0wt% to about 30wt%, acetic acid of 0wt% to about 10wt%, glutamic acid of 0wt% to about 0.4wt%, potassium acetate of 0wt% to about 0.4wt%, and potassium nitrate of 0wt% to about 2wt%, corrosion inhibitor having aminotetrazole of 0wt% to about 1wt%, and ethylene glycol of 0wt% to about 10wt%, additive having iminodiacetic acid of 0wt% to about 3wt%, etching regulator having sulfonic acid of 0wt% to about 5wt%, and para-toluene sulfonic acid of 0wt% to about 2wt%, and fluoride-containing compound of less than about 2wt%.

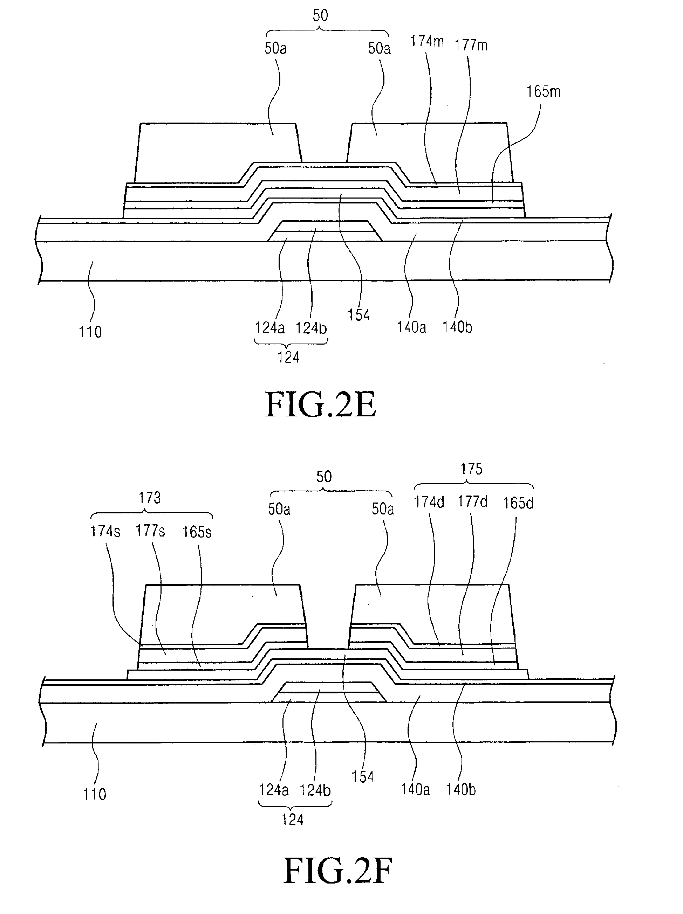

An exemplary embodiment of an etch back process will be described in detail below with reference to FIG. 2E. The etch back process is a process of uniformly removing the photo resists 50 (50a and 50b) by a predetermined thickness by known ashing. The predetermined thickness may be an entire thickness of a photo resist 50b overlapping the channel portion. The third source sub-electrode 174s and the third drain sub-electrode 174d are formed and the second metal material 174m overlapping the channel portion is exposed by the etch back process.

An exemplary embodiment of a channel part etching process will be described in detail below with reference to FIG. 2F. The second metal material 174m, the first metal material 177m, and the second oxide material 165m, uncovered at the channel part with by the photo resist film 50, are etched out in the channel part etching process. The portions of the second metal material 174m, the first metal material 177m, and the second oxide material 165m, which are etched out, substantially overlap the channel portion of TFT. The source electrode 173, the drain electrode 175, and the channel portion of TFT are formed in the channel part etching process. The second metal material 174m forms the third source sub-electrode 174s and the third drain sub-electrode 174d, the first metal material 177m forms the second source sub-electrode 177s and the second drain sub-electrode 177s, and the second oxide material 165m forms the first source sub-electrode 165s and the first drain sub-electrode 165d. The channel part etching process may be performed by the first etchant, not including the oxidation auxiliary, described above with reference to FIG. 2A. In another exemplary embodiment, the channel part etching may be performed by a etchant including oxidizer having ammonium persulfate of 0wt% to about 20wt%, oxidation auxiliary having sulfuric acid of 0wt% to about 3wt%, citric acid of 0wt% to about 30wt%, acetic acid of 0wt% to about 10wt%, glutamic acid of 0wt% to about 0.4wt%, potassium acetate of 0wt% to about 0.4wt% and potassium nitrate of 0wt% to about 2wt%, corrosion inhibitor having aminotetrazole of 0wt% to about 1wt% and ethylene glycol of 0wt% to about 10wt%, additive having iminodiacetic acid of 0wt% to about 3wt%, and etching regulator having sulfonic acid of 0wt% to about 5wt% and para-toluene sulfonic acid of 0wt% to about 2wt%.

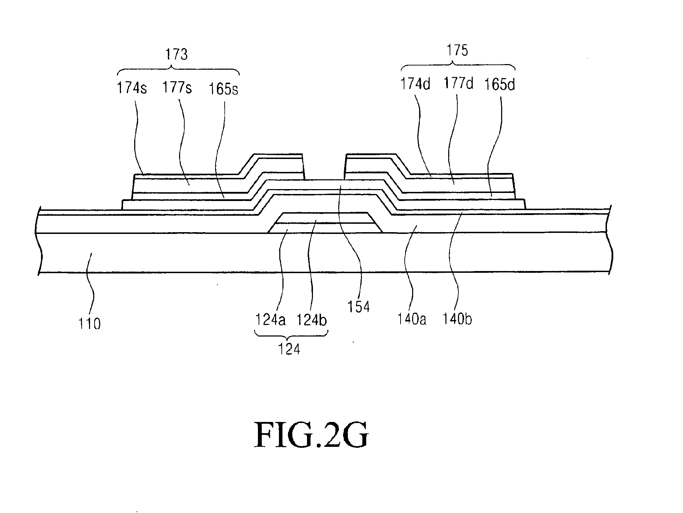

Referring to FIG. 2G, the first photo resist 50a on the third source sub-electrode 174s and the third drain sub-electrode 174d is removed. Thereafter, the semiconductor layer 154, the first source sub-electrode 165s, the first drain sub-electrode 165d, the second source sub-electrode 177s, the second drain sub-electrode 177d, the third source sub-electrode 174s, and the third drain sub-electrode 174d are formed by the methods described above with reference to FIGS. 2B to 2G.

Thereafter, the protection layer 180 is formed on the source electrode 173 and the drain electrode 175. Then, the TFT illustrated in FIG. 1 is finally formed. The protection layer 180 may include the first protection sub-layer 181 and the second protection sub-layer 183. The second protection sub-layer 183 may be formed on the first protection sub-layer 181. The first protection sub-layer 181 may include silicon oxide, and the second protection sub-layer 183 may include silicon nitride. In one exemplary embodiment of the invention, the first protection sub-layer 181 and the second protection sub-layer 183 may include the same materials as the above-described materials of the gate insulating layer 140 or an organic material. In one exemplary embodiment of the invention, either the first protection sub-layer 181 or the second protection sub-layer 183 may be omitted.

The TFT may be manufactured by the above-described processes or methods including reduced steps. In accordance with the exemplary embodiments of the TFT and manufacturing thereof according to the invention, an atom included in the semiconductor layer, or the source electrode and the drain electrode, may not be diffused into another layer, deoxidized or extracted, ensuring the high reliability of the TFT characteristics.

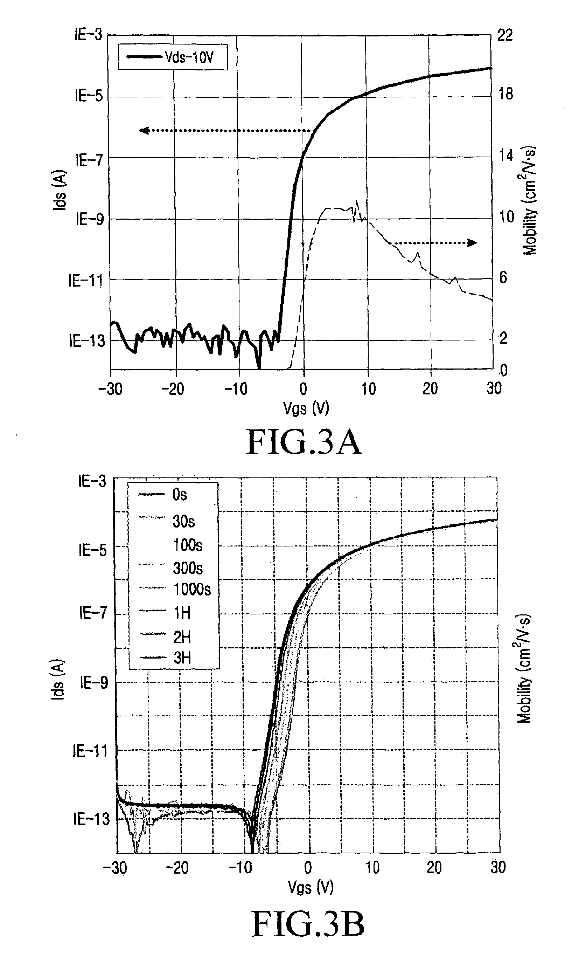

Characteristics of a TFT manufactured by the exemplary embodiment of the invention will be described in detail hereinbelow with reference to FIGS. 3A to 3B. FIG. 3A is a graph illustrating an I-V curve (current-voltage curve) and mobility values of a TFT at an initial time, and FIG. 3B is a graph illustrating an I-V curve of the TFT as time goes by.

The TFT was manufactured by the above-described methods or processes with reference to FIGS. 2A to 2G. More specifically, the TFT was manufactured by a method described below. The gate electrode 124 including the first gate sub-electrode 124a having titanium (Ti) and the second gate sub-electrode 124b having copper (Cu) was formed. The first etchant, described above with reference to FIG. 2A, was used to form the first gate sub-electrode 124a and the second gate sub-electrode 124b. The gate insulating layer 140 including the first gate insulating sub-layer 140a having silicon nitride and the second gate insulating sub-layer 140b having silicon oxide was formed. The semiconductor layer 154 including indium gallium zinc oxide was formed. The first source sub-electrode 165s and the first drain sub-electrode 165d including gallium zinc oxide were formed, the second source sub-electrode 177s and the second drain sub-electrode 177d including copper (Cu) were formed, and the third source sub-electrode 174s and the third drain sub-electrode 174d including copper (Cu)-manganese (Mn)-nitride were formed. A active etching process was performed by the first etchant described above with reference to FIG. 2A to 2D. A etch back process was performed by the first etchant, not including the oxidation auxiliary, described above with reference to FIG. 2E. A first protection sub-layer 181 including silicon oxide was formed, and a second protection sub-layer 183 including silicon nitride was formed. The first gate sub-electrode 124a was about 100Å thick, the second gate sub-electrode 124b was about 5,000Å thick, the first gate insulating sub-layer 140a was about 4,000Å thick, the gate insulating sub-layer 140b was about 500Å thick, the semiconductor layer 154 was about 500Å thick, the first source sub-electrode 165s and the first drain sub-electrode 165d was about 300Å thick, the second source sub-electrode 177s and the second drain sub-electrode 177d was about 2,000Å thick, the third source sub-electrode 174s and the third drain sub-electrode 174d was about 300Å thick, the first protection sub-layer 181 was about 1,000Å thick, and the second sub-protection layer 183 was about 1,000Å thick.

It can be understood from FIG. 3A that the TFT, manufactured with reference to method described above, had good characteristics. In FIGS. 3A and 3B, the x axis is voltage values (Vgs) in volts (V) applied to the gate electrode 124, the y axis are current values (Ids) in amperes (A) and mobility values in squared centimeters per volt seconds (cm²/V·s) with respect to a voltage applied to the gate electrode 124. The voltage difference between the source electrode and the drain electrode was about 10 V (voltage). The I-V characteristic of TFT illustrated in the graph of the FIG. 3B was measured at an initial time, after about 30 seconds, after about 100 seconds, after about 300 seconds, after about 1000 seconds, after about 1 hour, after 2 hours, and after about 3 hours. It can be understood from FIG. 3B that the TFT manufactured by the exemplary embodiment of the invention had substantially constant characteristics even for a long time, ensuring the high reliability of the TFT characteristics.

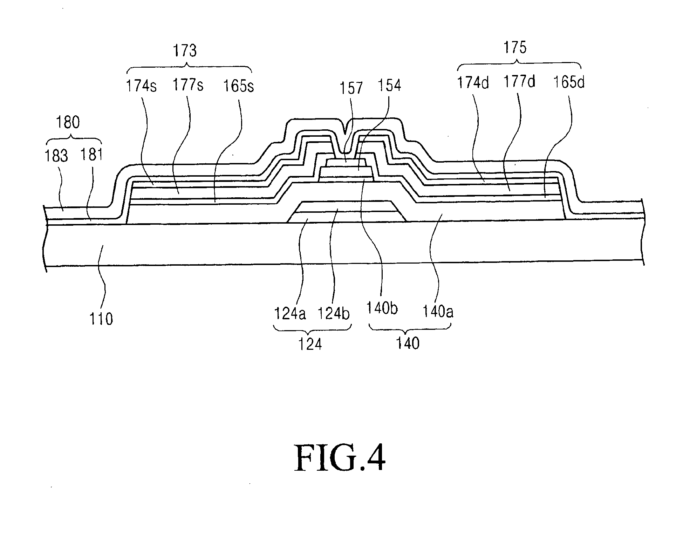

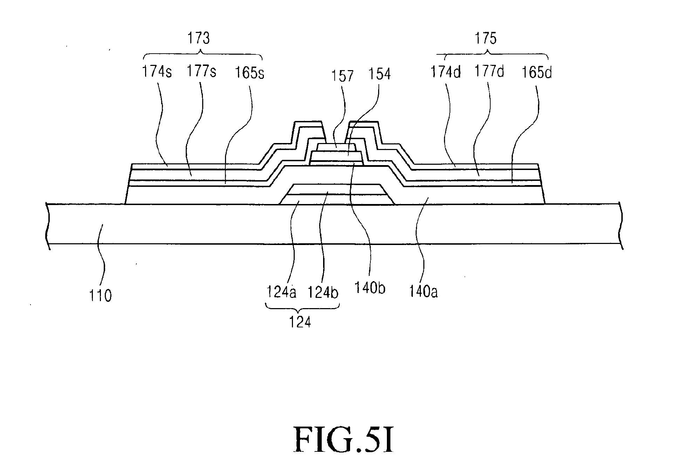

Hereinbelow, another exemplary embodiment of a TFT and a manufacturing method thereof according to the invention will be described in detail with reference to FIGS. 4 and 5I. FIG. 4 is a cross-sectional view of an exemplary embodiment of a TFT according to the invention. A structure of the TFT will be described in detail with reference to FIG. 4. Descriptions of materials or structures of the TFT described with reference to FIG. 1 will be omitted to avoid redundant description. A TFT illustrated in FIG. 4 has gallium-zinc oxide (GaZnO) group layer including any one surface directly contacting an oxide semiconductor and an oxide layer, and another surface directly contacting a copper (Cu) layer or a copper alloy layer.

The gate electrode 124 is on the substrate 110. The gate electrode 124 may include the first gate sub-electrode 124a and the second gate sub-electrode 124b. The gate electrode 124 may include the same materials and thickness as the above-described materials and thickness of the gate electrode 124 with reference to FIG. 1.

The gate insulating layer 140 is on the gate electrode 124. The gate insulating layer 140 may have the first gate insulating sub-layer 140a directly contacting the gate electrode 124, and the second gate insulating sub-layer 140b directly contacting the semiconductor layer 154, the first source sub-electrode 165s and the first drain sub-electrode 165d. The gate insulating layer 140 may include the same materials and thickness as the above-described materials and thickness of the gate insulating layer 140 with reference to FIG. 1. The second gate insulating sub-layer 140b may be substantially the same size as the size of the semiconductor layer 154 thereon, for example, in the plan view where edges thereof are aligned. The semiconductor layer 154 is on the second gate insulating sub-layer 140b. The semiconductor layer 154 may overlap the gate electrode 124. The semiconductor layer 154 may include the same materials and thickness as the above-described materials and thickness of the semiconductor layer 154 with reference to FIG. 1. The semiconductor layer 154 may be smaller than the gate electrode 124 in width, where the width is taken parallel to the substrate 110.

An etch-back layer 157 is on the semiconductor layer 154. The etch-back layer 157 may protect the semiconductor layer 154 in a channel part etching process described below in detail with reference to FIG. 5I. The etch-back layer 157 may be smaller than the semiconductor layer 154 in width. The etch-back layer 157 may include the same materials as the above-described materials of the first gate insulating sub-layer 140a or the second gate insulating sub-layer 140b with reference to FIG. 1. The etch-back layer 157 may include silicon oxide. The etch-back layer 157 may be about 100Å to about 2,000Å thick.

The source electrode 173 and the drain electrode 175, spaced apart from each other, are directly on the semiconductor layer 154, the etch-back layer 157 and/or the first gate insulating sub-layer 140a. The source electrode 173 may include the first source sub-electrode 165s, the second source sub-electrode 177s and the third source sub-electrode 174s, and the drain electrode 175 may include the first drain sub-electrode 165d, the second drain sub-electrode 177d and the third drain sub-electrode 174d. The source electrode 173 and the drain electrode 175 may include the same materials and thickness described above with reference to FIG. 1. The first source sub-electrode 165s and the first drain sub-electrode 165d may directly contact the first gate insulating sub-layer 140a and the etch-back layer 157.

The protection layer 180 is on the source electrode 173, the drain electrode 175, the gate insulating layer 140 and/or the etch-back layer 157. The protection layer 180 may include the first protection sub-layer 181 directly contacting the third source sub-electrode 174s, the third drain sub-electrode 174d, the first gate insulating sub-layer 140a, and/or the etch-back layer 157, and the second protection sub-layer 183 on the first protection sub-layer 181. The protection layer 180 may the same materials and thickness described above with reference to FIG. 1. In one exemplary embodiment of the invention, the first protection sub-layer 181 may be omitted. The TFT structured according to the exemplary embodiment of the invention may have excellent characteristics even after a long time.

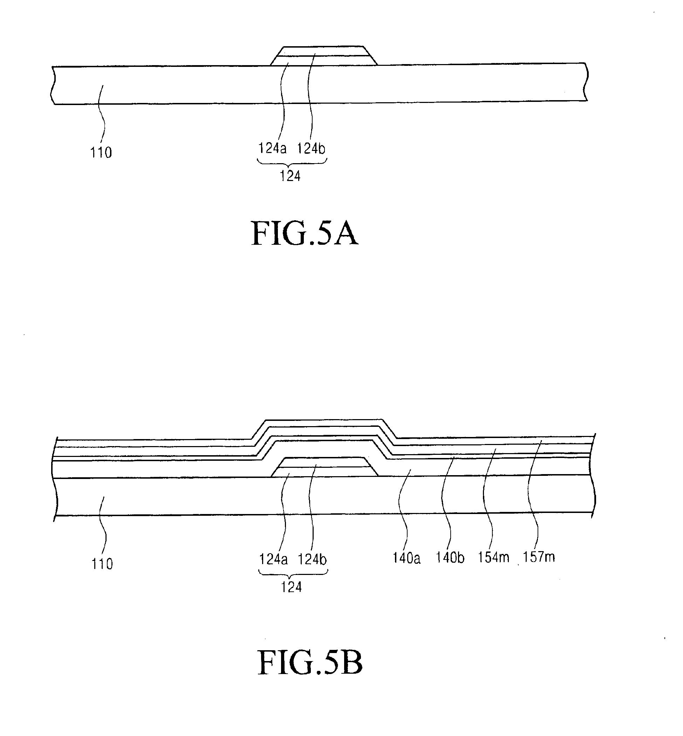

Hereinbelow, exemplary embodiments of methods for manufacturing the TFT illustrated in FIG. 1 will be described in detail with reference to FIGS, 5A to 5I. Descriptions of materials, structure, or methods of the TFT described with reference to FIGS. 1 to 4 will be omitted to avoid redundant description. FIG. 5A to 5I are cross-sectional views illustrating an exemplary embodiment of a method for manufacturing the TFT shown in FIG. 4 according to the invention. Referring to FIG. 5A, the first gate sub-electrode 124a and the second gate sub-electrode 124b are formed on a substrate 110. Materials, thickness and methods to form patterns of the gate electrode 124 may be the same as those described above with reference to FIG. 2A.

Referring to FIG. 5B, the first gate insulating sub-layer 140a is formed on the gate electrode 124, the second gate insulating sub-layer 140b is formed on the first gate insulating sub-layer 140a, the first oxide material 154m is formed on the second gate insulating sub-layer 140b, and a etch-back material 157m is formed the first oxide material 154m. The first gate insulating sub-layer 140a, the second gate insulating sub-layer 140b, the first oxide material 154m, and the etch-back material 157m may include the same materials as the materials, which are included in the first gate insulating sub-layer 140a, the second gate insulating sub-layer 140b and/or the semiconductor layer 154, described above with reference to FIG. 1. In one exemplary embodiment of the invention, the first gate insulating sub-layer 140a may include silicon nitride (SiNx), the second gate insulating sub-layer 140b may include silicon oxide (SiOx), the first oxide material 154m may include indium gallium zinc oxide (InGaZnO), and the etch-back material 157m may include silicon oxide (SiOx). The silicon nitride (SiNx), the silicon oxide (SiOx), the indium gallium zinc oxide (InGaZnO), and silicon oxide (SiOx) may be formed by the same methods described with reference to FIG. 2B.

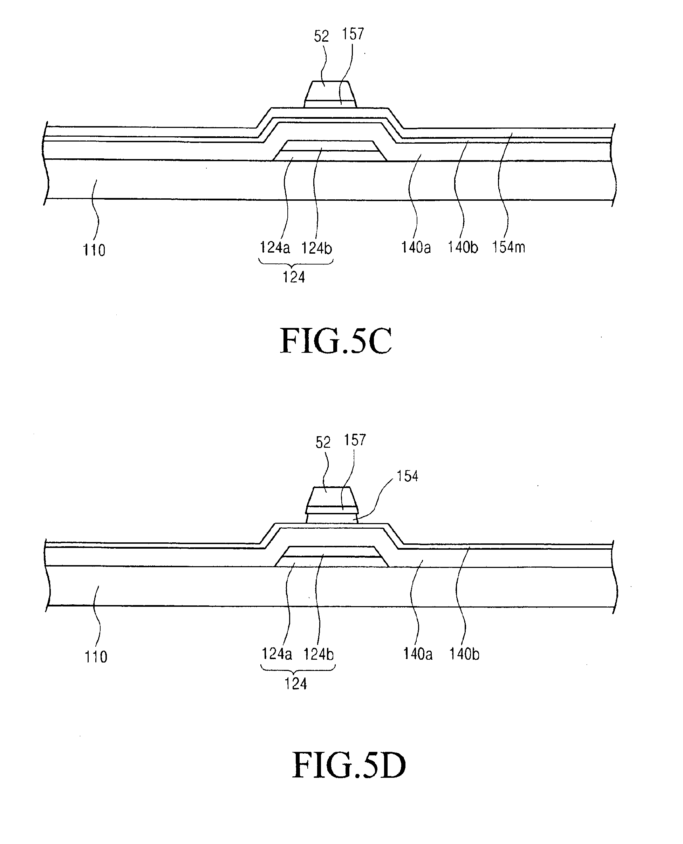

Referring to FIG. 5C, the etch-back material 157m is patterned in a etching process by using a patterned photo resist 52 as a mask to form a etch-back layer 157. The etch-back material 157m may be etched by dry etching or wet etching. The etch-back layer 157 overlaps the semiconductor layer 154.

Referring to FIG. 5D, the first oxide material 154m is etched by using the patterned photo resist 52 and the etch-back layer 157 as a mask to form a semiconductor layer 154. The first oxide material 154m may be etched by the first etchant, not including the oxidation auxiliary, described above with reference to FIG. 2A. An entire of the semiconductor layer 154 may overlap the gate electrode 124. In contrast, the previous exemplary embodiment shown in FIG. 2D includes an entire of the gate electrode 124 overlapped by the semiconductor layer 154.

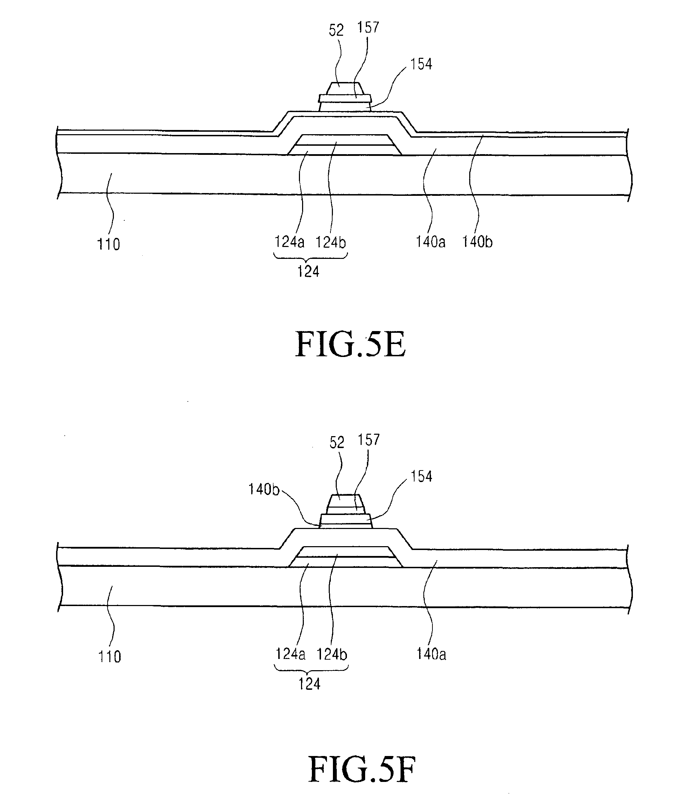

Referring to FIG. 5E, the patterned photo resist 52 is uniformly removed by a predetermined thickness by known ashing. A photo resist pattern 52, formed by the ashing process, may be less about 0.2 micrometer ("µm") to about 6µm than the etch-back layer 157 in width.

Referring to FIG. 5F, a portion of the etch-back layer 157 and a portion of the second gate insulating sub-layer 140b are etched together by using the photo resist pattern 52 as a mask. The portion of the second gate insulating sub-layer 140b is etched to form the final second gate insulating sub-layer 140b overlapping the gate electrode 124 and the semiconductor layer 154. An entire of the final second gate insulating sub-layer 140b overlaps the gate electrode 124 and the semiconductor layer 154, whereas the final second gate insulating sub-layer 140b illustrated in FIGS. 1 and 2G overlaps an entire of the gate electrode 124 and the semiconductor layer 154. The portion of the etch-back layer 157 and the portion of the second gate insulating sub-layer 140b may be etched by the etching process described above with reference to FIG. 5C. The etch-back layer 157 may be less than the semiconductor layer 154 in width.

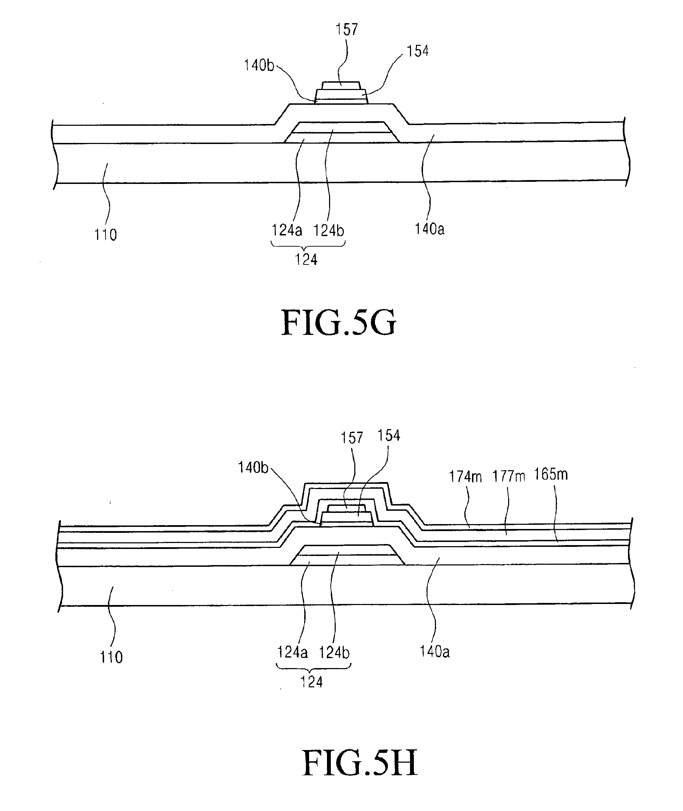

Referring to FIG. 5G, the photo resist pattern 52 on the etch-back layer 157 is removed.

Referring to FIG. 5H, the second oxide material 165m is formed directly on the first gate insulating sub-layer 140a, the semiconductor layer 154 and/or the etch-back layer 157, the first metal material 177m is formed on the second oxide material 165m, and the second metal material 174m is formed on the first metal material 177m. The second oxide material 165m includes gallium zinc oxide (GaZnO), the first metal material 177m may include copper (Cu), and the second metal material 174m may include copper manganese alloy (CuMn alloy). Methods for forming the second oxide material 165m, the first metal material 177m, and the second metal material 174m may be the same as the methods described above with reference to FIG. 2B.

Exemplary embodiments of methods for forming patterns of the source electrode 173, and the drain electrode 175 will be described below with reference to FIG. 5I The second oxide material 165m, the first metal material 177m, and the second metal material 174m may be etched together by using a photo resist pattern as a mask to form the source electrode 173 and the drain electrode 175. The second oxide material 165m, the first metal material 177m, and the second metal material 174m may be etched by the etchant for the channel part etching described above with reference to FIG. 2F. The source electrode 173 includes the first source sub-electrode 165s, the second source sub-electrode 177s and the third source sub-electrode 174s, and the drain electrode 175 includes the first drain sub-electrode 165d, the second drain sub-electrode 177d and the third drain sub-electrode 174d. The second metal material 174m forms the third source sub-electrode 174s and the third drain sub-electrode 174d, the first metal material 177m forms the second source sub-electrode 177s and the second drain sub-electrode 177d, and the second oxide material 165m forms the first source sub-electrode 165s and the first drain sub-electrode 165d.

The protection layer 180 is formed on the source electrode 173 and the drain electrode 175. Then, the TFT illustrated in FIG. 4 is finally formed. The protection layer 180 may include a first protection sub-layer 181 and a second protection sub-layer 183. In one exemplary embodiment of the invention, the first protection sub-layer 181 and the second protection sub-layer 183 may include the same materials and thickness as those described with reference to FIG. 1. In one exemplary embodiment of the invention, the first protection sub-layer 181 may be omitted, and the second protection sub-layer 183 may be formed on the source electrode 173 and the drain electrode 175. In accordance with the exemplary embodiments of the TFT and manufacturing thereof according to the invention, an atom included in the semiconductor layer or the source electrode and the drain electrode may not be diffused into another layer, deoxidized or extracted, ensuring the high reliability of the TFT characteristics.

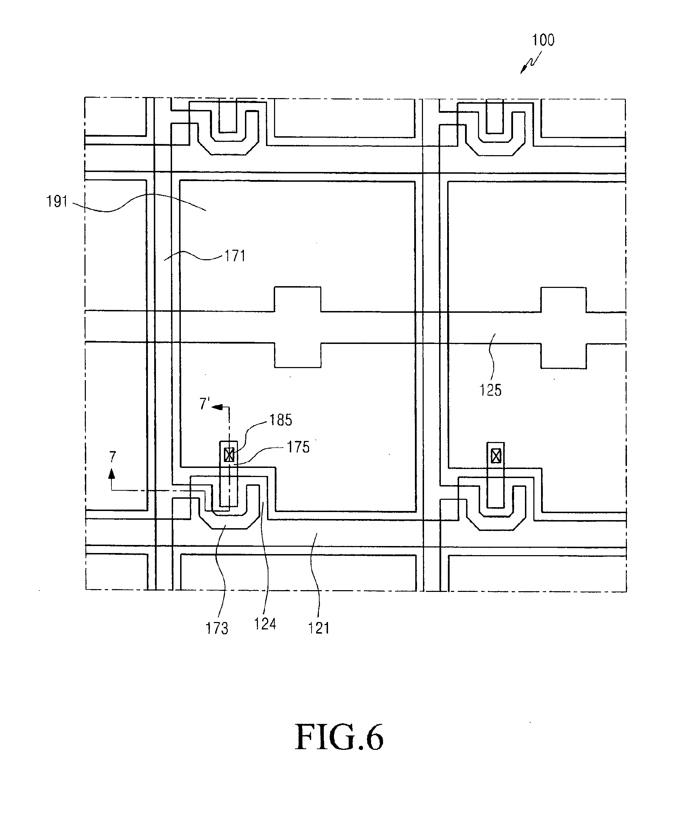

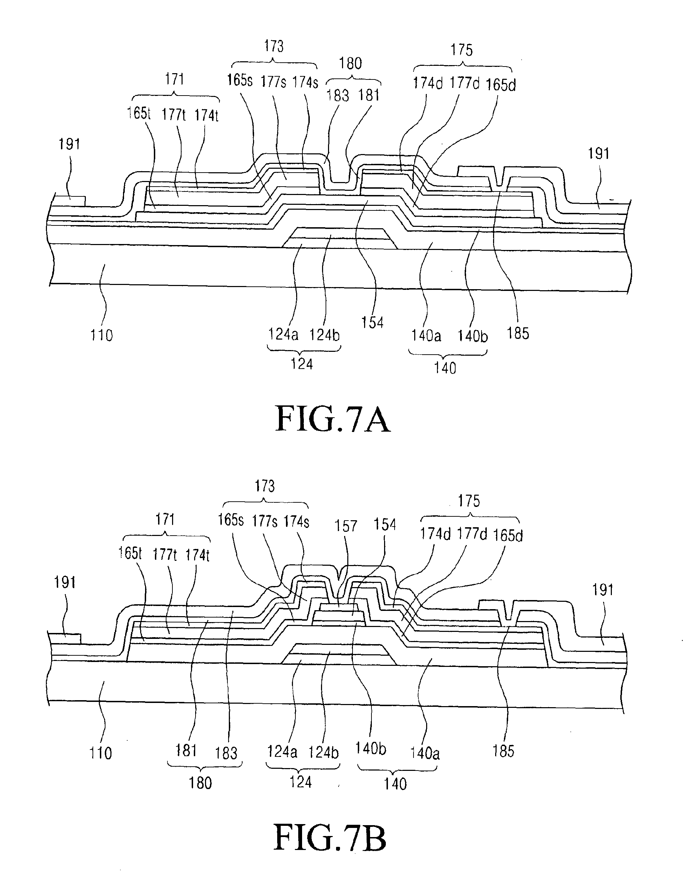

Exemplary embodiments of a TFT panel 100 according to the invention will be described hereinbelow with reference to FIGS. 6 to 7B. FIG. 6 is a plan view of an exemplary embodiment of a TFT panel according to the invention. FIGS. 7A to 7B are cross-sectional views taken along line 7-7' on the TFT panel 100 shown in FIG. 6. The TFT and its manufacturing methods described above with reference to FIGS. 1 to 2G and FIGS. 4 to 5I may be used in manufacturing the TFT panel 100. Therefore, redundant descriptions will be omitted in describing the TFT panel and its manufacturing methods.

An exemplary embodiment of the TFT panel 100 according to the invention will be described hereinbelow with reference to FIGS. 6 to 7A. A gate layer conductor (not shown) is formed on the substrate 110 including a glass or plastic material to form a plurality of gate lines 121, a plurality of gate electrodes 124, and a plurality of storage electrode lines 125. In one exemplary embodiment of the invention, the gate layer conductor may include a first gate layer (not shown) which forms the first gate sub-electrode 124a of the gate electrode 124 and a second gate layer (not shown) which forms the second gate sub-electrode 124b. The first gate sub-electrode 124a and the second gate sub-electrode 124b may be formed by the same manufacturing methods described above with reference to FIG. 1 and FIG. 2A. The substrate 110 is about 0.2 millimeter (mm) to about 0.7mm thick. The plurality of gate lines 121 mainly extend in the horizontal direction and transfer gate signals. Each of the plurality of gate lines 121 includes a plurality of gate electrodes 124 protruding from the gate line 121. The storage electrode lines 125 transfer a voltage, for example, a direct current ("DC") or predetermined swing voltages having two or more levels. In one exemplary embodiment of the invention, the gate lines 121, the storage electrode lines 125 and the gate electrode 124 may be formed simultaneously.

The gate insulating layer 140 is on the gate layer conductor. The gate insulating layer 140 may include the first gate insulating sub-layer 140a and the second gate insulating sub-layer 140b. In one exemplary embodiment of the invention, the gate insulating layer 140 may be formed by the same manufacturing methods described above with reference to FIG. 1 and FIG. 2B.

The semiconductor layer 154 is on the gate insulating layer 140, and a data line 171, the source electrode 173, and the drain electrode 175 is on the semiconductor layer 154. The data line 171 may include a first data sub-line 165t, a second data sub-line 177t, and a third data sub-line 174t, the source electrode 173 may include the first source sub-electrode 165s, the second source sub-electrode 177s, and the third source sub-electrode 174s, and the drain electrode 175 may include the first drain sub-electrode 165d, the second drain sub-electrode 177d, and the third drain sub-electrode 174d. In one exemplary embodiment of the invention, the semiconductor layer 154, the source electrode 173, and the drain electrode 175 may be formed by the same manufacturing methods described above with reference to FIG. 1 and FIGS. 2B to 2G.

The first data sub-line 165t may be formed by the second oxide material 165m, the second data sub-line 177t may be formed by the first metal material 177m, and the third data sub-line 174t may be formed by the second metal material 174m, described above with reference to FIG. 2B. In one exemplary embodiment of the invention, the first data sub-line 165t, the second data sub-line 177t, and the third data sub-line 174t may be formed by the same manufacturing methods for the source electrode 173 and the drain electrode 175 described above with reference to FIGS. 2B to 2G. In one exemplary embodiment of the invention, the first data sub-line 165t, the first source sub-electrode 165s and the first drain sub-electrode 165d may include the same material, and/or may be simultaneously formed by the same material. In one exemplary embodiment of the invention, the second data sub-line 177t, the second source sub-electrode 177s and the second drain sub-electrode 177d may include the same material, and/or may be simultaneously formed by the same material. In one exemplary embodiment of the invention, the third data sub-line 174t, the third source sub-electrode 174s and the third drain sub-electrode 174d may include the same material, and/or may be simultaneously formed by the same material.

In one exemplary embodiment of the invention, the first source sub-electrode 165s and the first drain sub-electrode 165d including gallium zinc oxide (GaZnO) may lower the contact resistance between the semiconductor layer 154 and the source electrode 173, or between the semiconductor layer 154 and the drain electrode 175. In one exemplary embodiment of the invention, the first source sub-electrode 165s and the first drain sub-electrode 165d including gallium zinc oxide (GaZnO) may reduce or effectively prevent extraction and deoxidization of an ion, for example, indium (In), included in the oxide semiconductor of the semiconductor layer 154. In one exemplary embodiment of the invention, the first source sub-electrode 165s and the first drain sub-electrode 165d including gallium zinc oxide (GaZnO) may effectively prevent a metal atom, for example, copper (Cu), included in the second source sub-electrode 177s and the second drain sub-electrode 177d from diffusing into the semiconductor layer 154. In one exemplary embodiment of the invention, the third data sub-line 174t, the third source sub-electrode 174s and the third drain sub-electrode 174d may reduce or effectively prevent the second data sub-line 177t, the second source sub-electrode 177s and second drain sub-electrode 177d from being lifted or corroded. In one exemplary embodiment of the invention, a material forming the third data sub-line 174t, the third source sub-electrode 174s and the third drain sub-electrode 174d can have good adhesion to a photo resist film in a process of manufacturing the TFT panel 100. The first data sub-line 165t may directly contact the semiconductor layer 154.

The protection layer 180 is on the gate insulating layer 140, the semiconductor layer 154, and/or the third data sub-line 174t, the third source sub-electrode 174s and the third drain sub-electrode 174d. The protection layer 180 may include the first protection sub-layer 181 and the second protection sub-layer 183. The protection layer 180 may be formed by the same manufacturing methods described above with reference to FIG. 1. The protection layer 180 has a plurality of contact holes 185 exposing ends of drain electrodes 175.

A plurality of pixel electrodes 191 is on the protection layer 180. A pixel electrode 191 is in electrical and/or physical connection with the drain electrode 175 via a contact hole 185, and receives a data voltage from the drain electrode 175. An electric field, generated by between the pixel electrode 191 receiving a data voltage and a common electrode (not shown) of the TFT panel 100 receiving a common voltage, determines directions of liquid crystal molecules in a liquid crystal layer (not shown) between two substrates of the TFT panel 100 or the two electrodes. The liquid crystal layer forms a liquid crystal capacitor with the two electrodes, and maintains the data voltage even after the TFT is turned off. The pixel electrode 191 may form a storage capacitor by overlapping the storage electrode line 125, thereby enhancing the liquid crystal capacitor's ability to maintain a voltage. The pixel electrode 191 may include a transparent conductor such as indium tin oxide ("ITO") or indium zinc oxide ("IZO"). The manufactured TFT panel 100 may maintain the outstanding characteristics of TFTs even for a long time.

An exemplary embodiment of a TFT panel 100 according to the invention will be described hereinbelow with reference to FIG. 6 and FIG. 7B. In one exemplary embodiment of the invention, the plurality of gate lines 121, the plurality of gate electrodes 124, and the plurality of storage electrode lines 125 may be formed on a substrate 110 by the same methods described above with reference to FIG. 6 and FIG. 7A.

The first gate insulating sub-layer 140a is on the gate electrode 124. The second gate insulating sub-layer 140b overlaps the gate electrode 124 and is on the first gate insulating sub-layer 140a.

The semiconductor layer 154 is on the second gate insulating sub-layer 140b, and the etch-back layer 157 is on the semiconductor layer 154. The first gate insulating sub-layer 140a, the second gate insulating sub-layer 140b, the semiconductor layer 154 and the etch-back layer 157 may be formed by the same methods described above with reference to FIG. 4 and FIGS. 5B to 5G.

The data line 171, the source electrode 173 and the drain electrode 175 are on the first gate insulating sub-layer 140a, the semiconductor layer 154 and/or the etch-back layer 157. The data line 171 may include the first data sub-line 165t, the second data sub-line 177t, and the third data sub-line 174t, the source electrode 173 may include the first source sub-electrode 165s, the second source sub-electrode 177s, and the third source sub-electrode 174s, and the drain electrode 175 may include the first drain sub-electrode 165d, the second drain sub-electrode 177d, and the third drain sub-electrode 174d. The source electrode 173 and the drain electrode 175 may be formed by the same methods described above with reference to FIG. 4 and FIGS. 5H to 5I.

The first data sub-line 165t may be formed by the second oxide material 165m, the second data sub-line 177t may be formed by the first metal material 177m, and the third data sub-line 174t may be formed by the second metal material 174m, described above with reference to FIG. 2B. The first data sub-line 165t, the second data sub-line 177t and the third data sub-line 174t may be formed by the same methods described above with reference to FIG. 4 and FIGS. 5H to 5I. The first data sub-line 165t may directly contact the first gate insulating sub-layer 140a. The first source sub-electrode 165s, the first drain sub-electrode 165d, the third data sub-line 174t and the third drain sub-electrode 174d may have the same effects as those described above with reference to FIG. 6 and FIG. 7A.

The protection layer 180 is on the gate insulating layer 140, the third source sub-electrode 174s, the third drain sub-electrode 174d, and/or the etch-back layer 157. In one exemplary embodiment of the invention, the protection layer 180 may include the first protection sub-layer 181 and the second protection sub-layer 183. The protection layer 180 may be formed by the same manufacturing methods described above with reference to FIG. 1. The protection layer 180 has the plurality of contact holes 185 exposing ends of drain electrodes 175.

The plurality of pixel electrodes 191 is on the protection layer 180. The pixel electrode 191 may be formed by the same manufacturing methods described above with reference to FIG. 6 and FIG. 7A.

The manufactured TFT panel 100 may maintain the outstanding characteristics of TFTs even for a long time.

While the invention has been shown and descried with reference to certain exemplary embodiment thereof, it will be understood by those skilled in the art that various changes in form and details may be made therein without departing from the scope of the invention as defined by the appended claims and their equivalents.

## Claims

1. A thin film transistor comprising;
a gate electrode and a gate insulating layer;
an oxide semiconductor layer on the gate insulating layer; and
a drain electrode and a source electrode spaced apart from each other, and on the oxide semiconductor layer;
the drain electrode comprising;
a first drain sub-electrode directly on the oxide semiconductor layer, and
a second drain sub-electrode on the first drain sub-electrode, and
the source electrode comprising;
a first source sub-electrode directly on the oxide semiconductor layer, and
a second source sub-electrode on the first source sub-electrode;
wherein
the first drain sub-electrode and the first source sub-electrode include gallium zinc oxide (GaZnO),
the second source sub-electrode and the second drain sub-electrode include a metal atom, and
wherein
the drain electrode further comprises a third drain sub-electrode on the second drain sub-electrode, and
the source electrode further comprises a third source sub-electrode on the second source sub-electrode,
wherein the third drain sub-electrode and the third source sub-electrode include copper manganese (CuMn).

2. The thin film transistor of claim 1, wherein the first source sub-electrode or the first drain sub-electrode is substantially transparent.

3. The thin film transistor of claim 2, wherein the gallium zinc oxide (GaZnO) includes about 2 atomic % to about 20 atomic % of gallium, and about 80 atomic % to about 98 atomic % of zinc.

4. The thin film transistor of claim 3, wherein a carrier concentration of the first source sub-electrode or the first drain sub-electrode is higher than a carrier concentration of the oxide semiconductor layer.

5. The thin film transistor of claim 1, wherein a carrier concentration of the first source sub-electrode or the first drain sub-electrode is higher than a carrier concentration of the oxide semiconductor layer.

6. The thin film transistor of claim 2, wherein a carrier concentration of the first source sub-electrode or the first drain sub-electrode is higher than a carrier concentration of the oxide semiconductor layer

7. The thin film transistor of claim 1, wherein the gallium zinc oxide (GaZnO) includes about 2 atomic % to about 20 atomic % of gallium, and about 80 atomic % to about 98 atomic % of zinc.

8. The thin film transistor of claim 8, wherein a carrier concentration of the first source sub-electrode or the first drain sub-electrode is higher than a carrier concentration of the oxide semiconductor layer.

## Patentansprüche

1. Dünnfilmtransistor, der Folgendes umfasst:
eine Gate-Elektrode und eine Gate-Isolierschicht;
eine Oxid-Halbleiterschicht auf der Gate-Isolierschicht; und
eine Drain-Elektrode und eine Source-Elektrode, die voneinander beanstandet und auf der Oxid-Halbleiterschicht angeordnet sind;
wobei die Drain-Elektrode umfasst:
eine erste Drain-Subelektrode direkt auf der Oxid-Halbleiterschicht, und
eine zweite Drain-Subelektrode auf der ersten Drain-Subelektrode, und
wobei die Source-Elektrode umfasst:
eine erste Source-Subelektrode direkt auf der Oxid-Halbleiterschicht, und eine zweite Source-Subelektrode auf der ersten Source-Subelektrode; wobei
die erste Drain-Subelektrode und die erste Source-Subelektrode Galliumzinkoxid (GaZnO) umfassen,
die zweite Source-Subelektrode und die zweite Drain-Subelektrode ein Metallatom umfassen,
und wobei
die Drain-Elektrode ferner eine dritte Drain-Subelektrode auf der zweiten Drain-Subelektrode umfasst, und
die Source-Elektrode ferner eine dritte Source-Subelektrode auf der zweiten Source-Subelektrode umfasst,
wobei die dritte Drain-Subelektrode und die dritte Source- Subelektrode Kupfermangan (CuMn) umfassen.

2. Dünnfilmtransistor gemäß Anspruch 1, wobei die erste Source-Subelektrode oder die erste Drain-Subelektrode im wesentlichen transparent ist.

3. Dünnfilmtransistor gemäß Anspruch 2, wobei das Galliumzinkoxid (GaZnO) etwa 2 Atomprozent bis etwa 20 Atomprozent Gallium und etwa 80 Atomprozent bis etwa 98 Atomprozent Zink umfasst.

4. Dünnfilmtransistor gemäß Anspruch 3, wobei eine Trägerkonzentration der ersten Source-Subelektrode oder der ersten Drain-Subelektrode höher ist als eine Trägerkonzentration der Oxid-Halbleiterschicht.

5. Dünnfilmtransistor gemäß Anspruch 1, wobei eine Trägerkonzentration der ersten Source-Subelektrode oder der ersten Drain-Subelektrode höher ist als eine Trägerkonzentration der Oxid-Halbleiterschicht.

6. Dünnfilmtransistor gemäß Anspruch 2, wobei eine Trägerkonzentration der ersten Source-Subelektrode oder der ersten Drain-Subelektrode höher ist als eine Trägerkonzentration der Oxid-Halbleiterschicht.

7. Dünnfilmtransistor gemäß Anspruch 1, wobei das Galliumzinkoxid (GaZnO) etwa 2 Atomprozent bis etwa 20 Atomprozent Gallium und etwa 80 Atomprozent bis etwa 98 Atomprozent Zink umfasst.

8. Dünnfilmtransistor gemäß Anspruch 7, wobei eine Trägerkonzentration der ersten Source-Subelektrode oder der ersten Drain-Subelektrode höher ist als eine Trägerkonzentration der Oxid-Halbleiterschicht.

## Revendications

1. Un transistor à couches minces comprenant :
Une électrode grille et une couche isolante de grille ;
Une couche semi-conductrice d'oxyde sur la couche isolante de grille, et
Une électrode déversoir et une électrode source espacée l'une de l'autre,
et sur la couche semi-conductrice d'oxyde ;
L'électrode déversoir comprenant :
Une première sous-électrode déversoir directement sur la couche semi-conductrice d'oxyde, et
Une deuxième sous-électrode déversoir sur la première sous-électrode déversoir sur la première sous-électrode déversoir, et l'électrode source comprenant :
Une première sous-électrode source directement sur la couche semi-conductrice d'oxyde, et
Une deuxième sous-électrode source sur la première sous-électrode source ;
Où
La première sous-électrode déversoir et la première sous-électrode source incluent de l'oxyde de zinc de gallium (GaZnO),
La deuxième sous-électrode source et la deuxième sous-électrode déversoir incluent un atome de métal, et
Où
L'électrode déversoir comprend de plus, une troisième sous-électrode déversoir sur la deuxième sous-électrode déversoir, et
L'électrode source comprend de plus une troisième sous-électrode source sur la deuxième sous-électrode source,
Où la troisième sous-électrode déversoir et la troisième sous-électrode source incluent du manganèse-cuivre (CuMn).

2. Le transistor à couches minces de la revendication 1, où la première sous-électrode source ou la première sous-électrode déversoir est substantiellement transparente.

3. Le transistor à couches minces de la revendication 2, où l'oxyde de zinc de gallium (GaZnO) inclut environ 2 % atomiques à environ 20 % atomiques de gallium, et environ 80 % atomiques à environ 98% atomiques de zinc.

4. Le transistor à couches minces de la revendication 3, où une concentration porteuse de la première sous-électrode source ou la première sous-électrode déversoir est supérieure à une concentration porteuse de la couche semi-conductrice d'oxyde.

5. Le transistor à couches minces de la revendication 1, où une concentration porteuse de la première sous-électrode source ou la première sous-électrode déversoir est supérieure à une concentration porteuse de la couche semi-conductrice d'oxyde.

6. Le transistor à couches minces de la revendication 2, où une concentration porteuse de la première sous-électrode source ou la première sous-électrode déversoir est supérieure à une concentration porteuse de la couche semi-conductrice d'oxyde.

7. Le transistor à couches minces de la revendication 1, où l'oxyde de zinc de gallium (GaZnO) inclut environ 2 % atomiques à environ 20 % atomiques de gallium, et environ 80 % atomiques à environ 98 % atomiques de zinc.

8. Le transistor à couches minces de la revendication 7, où une concentration porteuse de la première sous-électrode source ou la première sous-électrode déversoir est supérieure à une concentration porteuse de la couche semi-conductrice d'oxyde.
